Europäisches Patentamt

European Patent Office

Office européen des brevets

(19)

(11) Numéro de publication: **0 095 416**

**A1**

(12)

# DEMANDE DE BREVET EUROPEEN

(21) Numéro de dépôt: **83401013.4**

(22) Date de dépôt: **20.05.83**

(51) Int. Cl.³: **G 03 D 3/04**
**G 03 F 7/26**

(30) Priorité: **25.05.82 FR 8209037**

(43) Date de publication de la demande:
**30.11.83 Bulletin 83/48**

(84) Etats contractants désignés:
**DE NL SE**

(71) Demandeur: **PHOTOMECA S.A.**
**12, rue du Placieux**
**F-54000 Nancy Meurthe-et-Moselle(FR)**

(72) Inventeur: **Ferrante, Mario**
**12, rue du Placieux**
**F-54000 Nancy(FR)**

(74) Mandataire: **Chevallier, Robert**
**Cabinet BOETTCHER 23, rue La Boétie**
**F-75008 Paris(FR)**

(54) **Procédé et machine pour le développement de plaques de tous types à couche photosensible photopolymérisable.**

(57) Procédé et machine pour le développement de plaques de tous types à couche photosensible photopolymérisable.

Sous le fond plat (6) d'un bac concave (5) contenu dans une cuve (1) est fixé un transducteur (7) apte à créer des ultrasons dans le bain (10) pendant la circulation au sein de celui-ci, sous un couvercle (12), entre des rouleaux d'entraînement (8, 9), d'une plaque (P) à couche photosensible préalablement photopolymérisée.

EP 0 095 416 A1

Procédé et machine pour le développement de plaques de tous types à couche photosensible photopolymérisable.

L'invention a pour objet un procédé dynamique utilisable pour le développement automatique des plaques positives et négatives rigides généralement métalliques recouvertes d'une couche photosensible sur une face au moins, utilisées dans le domaine de l'impression offset; elle concerne aussi une machine servant à la mise en oeuvre de ce procédé.

L'exposition de la couche photosensible d'une plaque ou d'une feuille à un rayonnement approprié a pour effet de durcir ou de ramollir les parties frappées par ce rayonnement. Le développement a pour rôle d'éliminer à l'aide d'un solvant convenable les parties qui ne serviront pas à l'impression.

Certaines plaques peuvent être développées par un simple trempage dans un bain; d'autres nécessitent un brossage.

Si l'on s'en tient, pour fixer les idées, au seul exemple des plaques offset, on constate qu'il existe un grand nombre de fabricants de plaques dont la couche sensible a une composition et une dureté qui varient notablement d'un fabricant à un autre.

Le but principal de l'invention est de parvenir à une machine automatique d'emploi polyvalent capable de développer toutes les plaques à couche sensible disponibles dans le commerce.

Une telle machine doit donc s'accomoder des différences de formats des plaques et elle doit être apte à traiter les couches sensibles de diverses natures sans les détériorer et sans nécessiter de réglage complexe.

De plus, certains bains de développement s'oxydent à l'air. Il est donc très souhaitable de parvenir à une machine de développement dans laquelle le bain est protégé du contact de l'air, en dépit de la diversité des moyens habituels qui sont mis en oeuvre selon les procédés connus en fonction de la nature des couches sensibles : simple trempage, pulvérisation sous pression, éponge frottante, etc.....

On atteint ce but, selon l'invention, grâce à un procédé nouveau dans ce domaine selon lequel on fait tremper et de préférence on fait circuler la plaque dans un bain de révélateur approprié cependant qu'on soumet ce bain à l'effet d'un générateur d'ultrasons.

Le bain est contenu dans un bac et le transducteur qui engendre les ultrasons dans le bain est fixé à une paroi du bac, de préférence à l'extérieur. Le bac est fermé par un couvercle. Le transducteur peut être fixé à ce dernier.

Dans un mode de réalisation préféré d'une machine conforme à l'invention le bain est contenu dans un bac concave et ce premier bac est lui-même disposé dans une cuve extérieure. Dans ce cas, il est avantageux de placer le transducteur contre le fond du premier bac, à l'extérieur de ce dernier mais à l'intérieur de la cuve extérieure.

Le générateur d'ultrasons a une puissance minimale de 100 W environ et il fonctionne à une fréquence supérieure à 20.000 Hz jusqu'à 50.000 Hz.

Le procédé de l'invention s'applique à toutes les plaques et il a le même effet efficace avec tous les bains. Il supprime les brosses et leur encrassement ainsi que le risque de détérioration des plaques par suite de frottement mécanique. La surface des plaques étant souvent micrograinée, l'effet des ultrasons permet de décoller les couches photosensibles au fond des pores.

Le liquide agité par les ultrasons produit, contrairement à toute attente, un effet de frottement plus efficace et moins dangereux que les brosses. En outre, la couche éliminée est entraînée aussitôt loin de la plaque de sorte que la surface de celle-ci est maintenue plus propre que par les brosses et que la morsure du bain sur la couche attaquée est plus vive et plus profonde. L'oxydation du bain - quand il s'agit d'un liquide sensible à l'oxydation - est réduite puisque la surface exposée du bain est limitée ; la possibilité d'utiliser un couvercle que le bain peut venir lécher limite encore l'oxydation. De plus, les ultra-sons produisent un dégazage efficace du révélateur et limitent ainsi son oxydation.

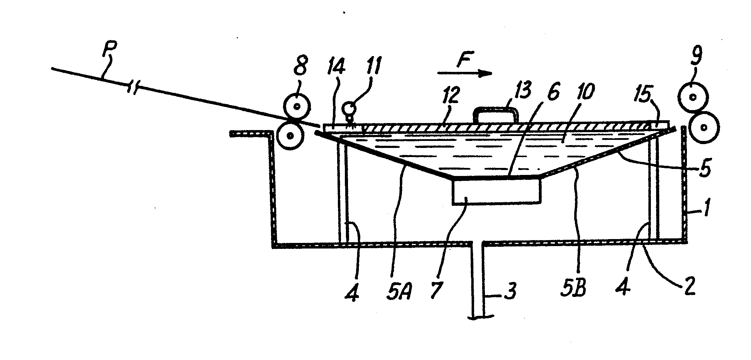

A titre d'exemple, on donnera maintenant une description d'un mode préféré de réalisation d'une machine conforme à l'invention. On se reportera à la figure unique annexée qui est une vue schématique d'une double cuve pour la révélation de plaques offset selon le procédé de l'invention.

Une cuve 1 a un fond 2 muni d'un tube de vidange 3 et contient une structure porteuse 4. Celle-ci sert à soutenir un bac concave 5 qui est, plus exactement, à fond plat 6 avec deux parois longitudinales 5A, 5B inclinées chacune vers l'extérieur et deux parois latérales verticales. A l'extérieur du fond plat 6 et à l'intérieur de la cuve 1, est monté un transducteur 7 qui est réuni par un câble (non représenté) à un générateur d'énergie à haute fréquence (non représenté) installé en dehors de la cuve 1. Cet équipement à ultrasons est disponible dans le commerce; il fonctionne à une puissance minimale de 100 W et produit des ultrasons à une fréquence de 20.000 à 50.000 Hz.

A proximité du bord supérieur des parois 5A,5B du bac 5 sont disposées deux paires de cylindres entraîneurs, respectivement 8, 9. Les plaques à traiter circulent dans le sens indiqué par une flèche F, des cylindres 8 aux cylindres 9. Une machine complète comprend d'autres postes de traitement, de rinçage, de gommage, de séchage, qui sont totalement classiques et qu'il n'est pas nécessaire de décrire.

Le bac 5 contient un bain 10 approprié à la nature de la couche sensible des plaques offset à développer. Une rampe d'alimentation est disposée juste après les cylindres d'entraînement 8, au-dessus du bac 5. Celui-ci est constamment alimenté en bain frais, au débit qui convient; l'excédent tombe dans la cuve 1 puis il est évacué par le tube de vidange 3. Un couvercle 12 ayant une poignée 13 peut être posé entre les parois 5A, 5B en reposant sur elles par ses extrémités de façon à se trouver au niveau de la surface du bain. Ce couvercle a une ouverture d'entrée 14 juste après les cylindres 8 pour l'arrivée des plaques dans le bain et pour l'alimentation par la rampe 11, et une ouverture de sortie 15, juste avant les cylindres 9 pour le départ des

4   0095416

plaques. Ces dernières arrivent une à une avec une inclinaison, comme le montre la plaque P représentée, avec leur
face sensible tournée vers le haut, de façon à pouvoir
s'engager par l'ouverture d'entrée 14; elles plongent dans
le bain 10 jusqu'à ce que leur bord avant rencontre la
paroi 5B inclinée vers le haut. Celle-ci guide alors la
plaque vers l'ouverture de sortie 15 jusqu'aux cylindres 9
qui la saisissent et qui l'entraînent. Pour que la plaque
s'engage plus facilement entre les cylindres 8 et 9, ceux-
-ci sont inclinés sur la verticale d'une valeur convenable.
Naturellement, les cylindres 8 et 9 sont espacés d'une
distance inférieure à la longueur des plaques à traiter.
La profondeur du bac 5 est de l'ordre de quelques centimètres, 3 à 5 cm; elle a été exagérée sur la figure pour
une meilleure clarté du dessin.

Toutes les plaques à couche photosensible pour
impression offset ou typographique ou flexographique
peuvent être traitées par le procédé de l'invention. La
vitesse à laquelle on fait circuler les plaques à travers
le bain dépend de la concentration du révélateur dans le
bain ; avec le procédé de l'invention on peut atteindre
une vitesse moyenne de 1 m/mn à 4 m/mn.

Les dépressions créées par la cavitation
absorbent les gaz ($CO_2$ et $O_2$) qui nuisent à la qualité des
révélateurs. Cette décarbonatation et cette désoxydation
doublent la durée de vie des produits chimiques utilisés.

REVENDICATIONS

1. Procédé pour le développement d'une plaque relativement rigide à couche photosensible pour impression offset, typographique, flexographique dans un bain approprié caractérisé en ce qu'on fait circuler la plaque à travers le bain pendant que l'on soumet ce dernier à l'effet d'un générateur d'ultrasons.

2. Procédé selon la revendication 1 caractérisé en ce qu'on fait circuler la plaque à une vitesse choisie entre 1 et 4 m/mn.

3. Procédé selon la revendication 1 caractérisé en ce qu'on utilise des ultrasons à une fréquence supérieure à 20.000 Hz, de préférence jusqu'à 50.000 Hz.

4. Machine pour le développement d'une plaque relativement rigide à couche photosensible pour impression offset, typographique, flexographique, comprenant un bac (5), un bain (10) approprié contenu dans ce bac, caractérisée en ce que des rouleaux d'entraînement (8, 9) sont disposés respectivement à deux extrémités opposées du bac (5) avec un écartement inférieur à la longueur des plaques à traiter, ce bac (5) étant pourvu d'un transducteur (7) apte à créer des ultrasons dans le bain (10) pendant le passage de la plaque entre les rouleaux d'entraînement (8, 9).

5. Machine selon la revendication 4 caractérisée en ce que le bac (5) est concave avec deux parois longitudinales (5A, 5B) inclinées chacune vers l'extérieur et des rouleaux d'entraînement (8, 9) sont disposés au sommet de chacune de ces parois (5A, 5B) avec une inclinaison sur la verticale pour entraîner une plaque à travers le bain.

6. Machine selon la revendication 5 caractérisée en ce qu'elle comprend un couvercle (12) venant en contact avec la surface du bain (10) et ayant à ses extrémités voisines des rouleaux (8, 9) des ouvertures (14, 15) prévues pour l'entrée et la sortie de la plaque et pour l'alimentation du bac (5) en bain frais.

7. Machine selon la revendication 6 caractérisée en ce que le bac (5) est supporté dans une cuve plus grande (1) munie d'un tuyau de vidange (3).

0095416

1/1

Office européen
des brevets

**RAPPORT DE RECHERCHE EUROPEENNE**

EP  83 40 1013

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y | FR-A-2 078 702  (EASTMAN KODAK CO.)<br>* Pages 2,3 * | 1,3 | G 03 D    3/04<br>G 03 F    7/26 |
| Y | US-A-3 702 795  (F.A. WESSELS et al.)<br>* Colonnes 1-3; figures 1-3 * | 1,3 | |
| Y | US-A-4 179 208  (P.U. MARTIN)<br>* Colonnes 2-4; figures 1-5 * | 1 | |
| A | | 5 | |
| A | FR-A-1 534 506  (GEVAERT-AGFA N.V.)<br>*  Page 5, colonne 1, lignes 43-61; colonne 2; figure 9 * | 1,5,7 | DOMAINES TECHNIQUES RECHERCHES (Int. Cl. ³) |
| A | GB-A-1 495 745  (KODAK LTD)<br>*  Page 1, lignes 64-96; page 2, colonne 1, lignes 1-39; figures 1,2 * | 6 | G 03 D    3/04<br>G 03 F    7/26<br>G 03 D    3/13 |

Le présent rapport de recherche a été établi pour toutes les revendications

| Lieu de la recherche | Date d'achèvement de la recherche | Examinateur |
|---|---|---|
| LA HAYE | 02-09-1983 | BOEYKENS J.W. |